# EUROPÄISCHE PATENTSCHRIFT

(11) **EP 0 251 257 B1**
(45) Veröffentlichungstag und Bekanntmachung des Hinweises auf die Patenterteilung: **19.01.1994**
(21) Anmeldenummer: 87109260.7
(22) Anmeldetag: 27.06.1987
(51) Int. Cl.: H05K 3/34, B23K 1/00

(54) **Verfahren u. Anordnung zum Reflow-Löten und Reflow-Entlöten von Leiterplatten**
Method and device for reflow-soldering and reflow-desoldering of printed circuit boards
Méthode et dispositif pour la soudure et la désoudure à reflux de plaquettes à circuits imprimés

(30) Priorität: 03.07.1986 DE 3622336; 25.06.1987 DE 3720912
(43) Veröffentlichungstag der Anmeldung: 07.01.1988
(73) Patentinhaber: Deutsche Aerospace AG, 81663 München (DE)
(72) Erfinder: Ehler, Helmut, Ing., D-7910 Neu-Ulm (DE)
(74) Vertreter: Schulze, Harald Rudolf, Dipl.-Ing.

(56) Entgegenhaltungen:
- WO-A-85/03248
- US-A- 4 270 260

## Beschreibung

Die Erfindung betrifft ein Verfahren nach dem Oberbegriff des Anspruchs 1 sowie eine Anordnung zur Durchführung dieses Verfahrens. Ein solches Verfahren ist bereits aus der US-A-4 270 260 bekannt.

Zum Reflow-Löten von Leiterplatten sind verschiedene Infrarot-Durchlauföfen auf dem Markt. Diese weisen insbesondere folgende Nachteile auf: Wenn infolge einer Störung des Fertigungsablaufs (bei der Bestückung oder Lotdosierung) die Anlage abgeschaltet werden muß, kann es durch die große im Ofen gespeicherte Wärme zur Zerstörung des Lötguts kommen. Außerdem ist das Lötgut durch den Transport im Schmelz- und Erstarrungsbereich ständigen Erschütterungen ausgesetzt, die die Festigkeit und das Metallgefüge der Lötstellen negativ beeinflussen. Aus WO-A-85 03 248 ist ein Durchlauföfen zum Reflow-Löten von Leiterplatten bekannt.

Bekannt sind ferner Halogenpunktstrahler mit vergoldetem Reflektor, die mit von Hand reduzierter Betriebsspannung zum Reflow-Löten von Einzellötstellen geeignet sind.

Die aus der eingangs genannten US-A-4 270 260 bekannte Anordnung dient zum Reflow-Entlöten von Leiterplatten.

Bei dieser Anordnung wird die zu entlötende Leiterplatte von Hand in einen Ofen eingelegt und dort mit Hilfe von Klemmvorrichtungen befestigt. Unter der Leiterplatte sind mehrere Infrarotstrahler angeordnet, die während der Entlötphase und einer dieser Phase zeitlich vorgeschalteten Vorwärmphase die Leiterplatte von unten erwärmen, während gleichzeitig ein über der Leiterplatte angeordneter Ventilator die Oberseite der Leiterplatte mit den darauf befindlichen Bauelementen mit Kühlluft versorgt. Sobald das Lot flüssig geworden ist, werden die Bauelemente von Hand (z.B. mit einer Zange oder Pinzette) von der Leiterplatte entfernt. Die entlötete Leiterplatte wird anschließend von Hand aus dem Ofen entfernt.

Aufgabe der Erfindung ist es, ein Verfahren und eine Anordnung der eingangs genannten Art anzugeben, die für automatische Fertigungsstraßen geeignet sind, bei denen bei Ablaufstörungen das Lötgut nicht beschädigt wird und bei denen in den kritischen Lötphasen keine Erschütterungen auftreten.

Die Lösung dieser Aufgabe ist den Patentansprüchen 1 bzw. 14 zu entnehmen. Die weiteren Ansprüche beinhalten vorteilhafte Weiterbildungen bzw. Ausführungen der Erfindung.

Die Erfindung wird im folgenden anhand der Figuren näher erläutert. Figuren 1 und 2 zeigen eine erfindungsgemäße Anordnung schematisch im Längsschnitt und im Querschnitt, Figuren 3 und 6 zeigen gemessene Temperaturverlaufe von Lötstellen auf Leiterplatten verschiedener Dicke und aus verschiedenen Materialien, die nach dem erfindungsgemäßen Verfahren gelötet wurden.

Nach dem erfindungsgemäßen Verfahren können Leiterplatten 3 mit einer Dicke von ca. 0,1 bis ca. 2,5 mm gelötet werden, die z.B. aus Hartpapier, Hartgewebe, Epoxy-Glashartgewebe, Epoxy-Glashartgewebe-Multilayer mit z.B. Invar-Zwischenlagen oder aus Polyimid bestehen. Die zu lötenden Stellen sind mit flußmittelhaltiger Lotpaste versehen, in die die Lötanschlüsse oberflächen-montierbarer Bauteile (SMDs) eingedrückt sind, oder mit Lotformteilen, z.B. Lotringen über Drahtanschlüssen usw..

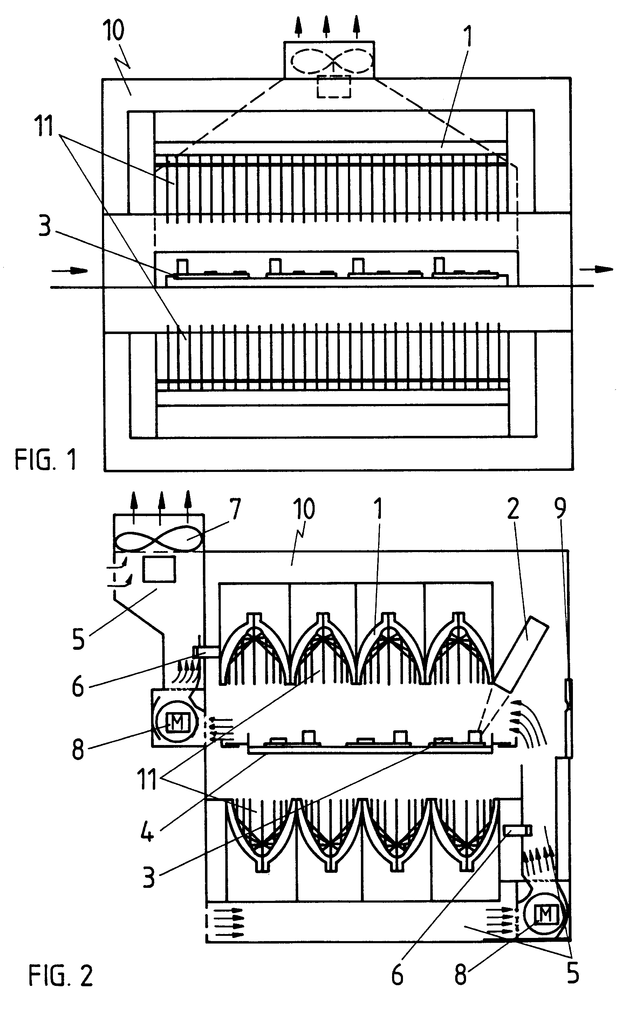

Die bestückten Leiterplatten 3 werden über ein automatisches Transportsystem - in Figur 1 von links nach rechts laufend - in den Ofen 10 gefahren. Vorteilhaft einsetzbar sind Werkstückträger 4 einer automatischen Fertigungsstraße. Das Transportsystem wird getaktet betrieben; während der Vorwärm- und Abkühl-Zwischenphase und der Löt- oder Entlötphase werden die Leiterplatten 3 nicht mehr bewegt, sondern verbleiben an einer festen Position im Ofen 10. Im Ofen 10 sind über und/oder unter dem Transportsystem in gleichem Abstand zu den Leiterplatten 3, vgl. Figur 1 und 2, jeweils mehrere Infrarot-Flächenstrahler 1 nebeneinander und gegebenenfalls auch hintereinander angeordnet. Diese weisen parabolförmige goldbeschichtete Reflektoren auf, die eine gleichmäßige Verteilung der Strahlung über die Leiterplatten 3 gewährleistet, wobei die von den Infrarot-Flächenstrahlern 1 erzeugten Wärmestrahlen nahezu parallel verlaufen und annähernd senkrecht auf der Ober- bzw. Unterseite der Leiterplatten 3 stehen. Die Infrarot (IR)-Wellenlänge liegt vorzugsweise zwischen etwa 1um und 3um.

Die IR-Flächenstrahler 1 weisen jeweils Regelschaltungen für den Betriebstrom auf. Jeder einzelne ist mit einem Stromsensor versehen, der über einen Regelkreis mit einer Phasenanschnittsteuerung gekoppelt den vorgewählten Betriebsstrom auf + 0,5% konstant hält. Ventilatoren 8 zum Erzeugen einer laminaren Luftströmung und zum Absaugen der Lötdämpfe, vgl. Figur 1 und 2, weisen ebenfalls Regelschaltungen für ihre Antriebsmotore M auf.

Die beiden Ventilatoren 8 sind jeweils in einem Schacht 5 angebracht. Der erste der beiden Schächte 5 weist eine nach außen gehende Eingangsöffnung auf und eine Ausgangsöffnung, die sich auf der einen Seite des Transportsystems etwa in dessen Höhe befindet. Der zweite der beiden Schächte 5 weist eine nach außen gehende Ausgangsöffnung auf und eine Eingangsöffnung, die sich auf der gegenüberliegenden Seite des Transportsystems etwa in dessen Höhe befindet. In der Nähe der Ausgangsöffnung des zweiten Schachts 5 ist im Inneren des Schachts zusätzlich ein dritter ungeregelter Ventilator 7 zum Absaugen des Gases und der Lötdämpfe angebracht. In der Nähe der beiden geregelten Ventilatoren 8 ist im Inneren des zugehörigen Schachts 5 jeweils ein Strömungssensor 6 angebracht, der Teil der Regelschaltung für den Antriebsmotor M des zugehörigen Ventilators 8 ist.

Die Regelung der geregelten Ventilatoren 8 ist so eingestellt, daß die Luft von außen über den ersten Schacht 5 an die eine Seite des Transportsystems herangeführt wird, anschließend laminar und horizontal quer zur Transportrichung der Leiterplatten 3 an diesen vorbeigeführt wird und über den zweiten Schacht 5 auf der anderen Seite des Transportsystems zusammen mit den Lötdämpfen wieder nach außen abgeführt wird. Der dritte Ventilator 7 unterstützt diesen Abführungsprozeß. wobei in einer vorteilhaften Ausführungsform vor dem Ventilator 7 zusätzliche Luftansaugöffnungen in dem Abluftschacht 5 vorgesehen sind.

Die Drehzahl der geregelten Ventilatoren 8 und des ungeregelten Ventilators 7 bzw. die Anzahl und Größe der zusätzlichen Luftansaugöffnungen in dem Abluftschacht 5 sind so bemessen, daß zumindest während der Vorwärm-Zwischenphase und der Löt- bzw. Entlötphase sowie während der Abkühl-Zwischenphase bis zum Erstarren des Lots auf den Leiterplatten 3 kein Unterdruck im Ofen 10 entsteht.

Weiterhin weist der Ofen 10 auf der dem Abluftschacht 5 gegenüberliegenden Seite in der Mitte, etwa in der Höhe des Transportsystems, ein aufklappbares durchsichtiges Sichtfenster 9 auf, das zum einen eine kontinuierliche Beobachtung der ablaufenden Prozesse im Ofen 10 ermöglicht und zum anderen bei Entlötvorgängen die Entnahme der entlöteten Bauteile per Hand (mit einer Pinzette oder einem Greifer) gestattet.

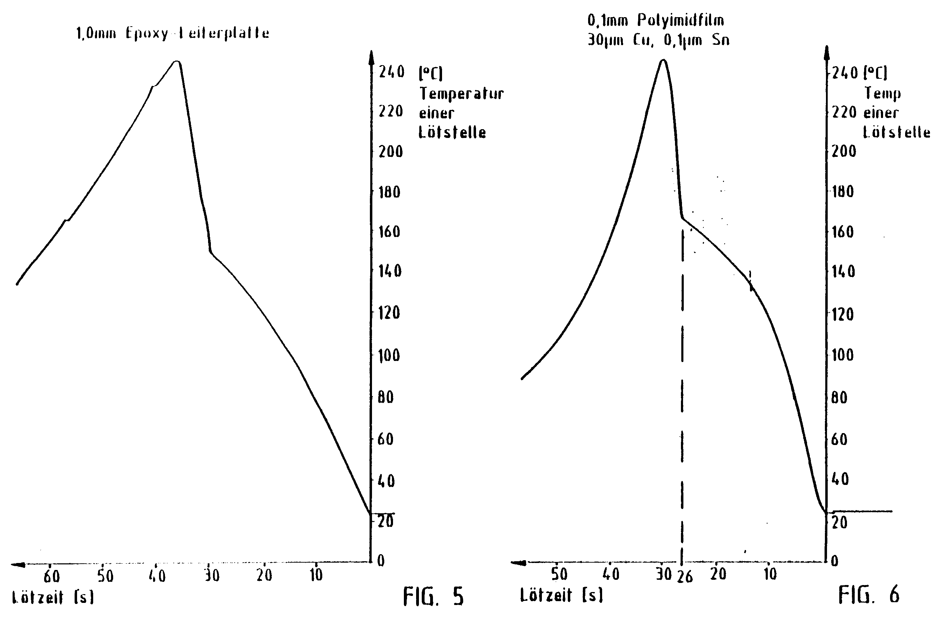

Ein typischer erfindungsgemäßer Verfahrensablauf beim Reflow-Löten wird im folgenden beschrieben. Bei diesem Beispiel wird auch die Lotpastentrocknung (Entgasen) in der erfindungsgemäßen Anordnung vorgenommen. Der zugehörige Temperaturverlauf einer ausgewählten Lötstelle ist in Figur 4 dargestellt. Zunächst werden beide Strahlergruppen 1 eingeschaltet und mit niedrigem Betriebsstrom betrieben, so daß während 90 Sekunden die Lotpaste trocknet und sich Leiterplatten 3 und Bauteile auf ca. 110°C erwärmen. Dann wird zum Vorwärmen über eine vorgegebene erste Zeit von ca. 20 sec der Betriebsstrom höher geschaltet (aber auf gegenüber dem Höchstwert immer noch reduziertem Niveau), so daß sich die bestückten Schaltungsträger 3 von 100 auf ca. 160°C erwärmen. Nun wird für eine zweite vorgegebene Zeit von 4 bis 8 sec. der Betriebsstrom der Flächenstrahler 1 auf eine höchste vorgegebene Stufe geschaltet und anschließend ganz abgeschaltet. In dieser kurzen Zeit erwärmen sich die Bauteile und Lötstellen auf ca. 240°C, wobei die Lotpaste schmilzt und die Bauteile sicher mit den Lötstellen verlötet werden.

Die Leiterplatten 3 kühlen nun im konstanten laminaren Luftstrom von ca. 0,5 m/sec der Ventilatoren 8 , die mit ca. 30% ihrer Nenndrehzahl betrieben werden, ab auf ca. 170°C. Die Ventilatoren 8 werden dann auf volle Drehzahl geschaltet, wodurch die an den Leiterplatten vorbeiströmende Luft diese rasch auf 60 bis 80°C abkühlt. Das Transportsystem mit den Leiterplatten 3 wird jetzt weitergetaktet zum Verlassen des Ofens und z.B. einer Durchlaufreinigungsanlage zugeführt.

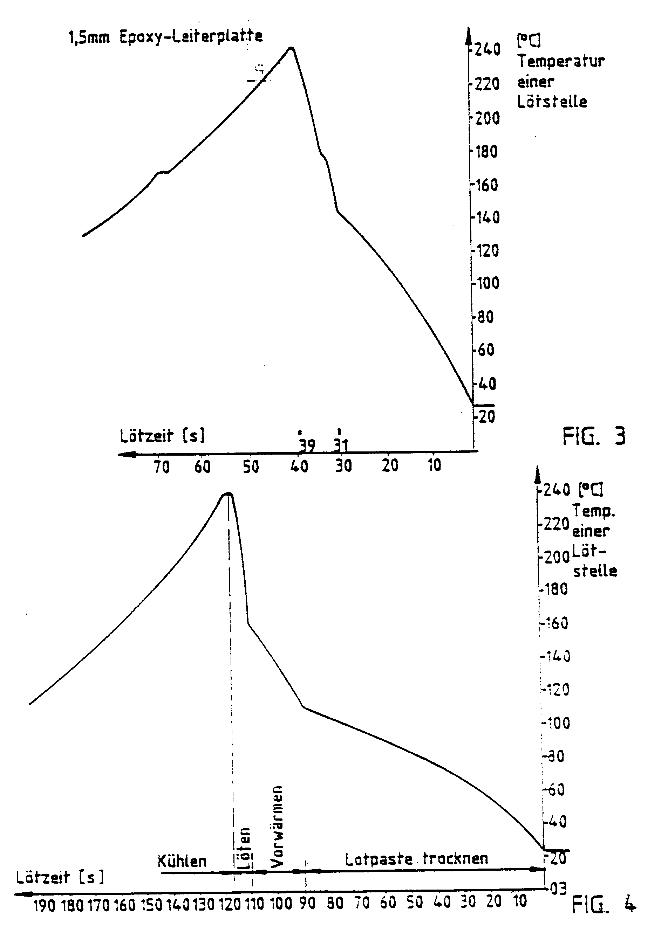

Die erforderlichen Höhen des Betriebsstroms und die jeweiligen Einschaltzeiten der einzelnen Betriebsstufen sind empirisch zu ermitteln in Abhängigkeit vom Lötgut. Es gehen ein die Dicke des Basismaterials, Masse der Bauteile, Lotart usw. Figuren 3, 5 und 6 zeigen Lötstellen-Temperaturverläufe für verschiedene Leiterplattentypen.

Diese Einstellparameter können als Lötprogramme zu den jeweiligen Leiterplattentypen in einer speicherprogrammierbaren Mikrosteuerung und -regelung abgespeichert werden und jederzeit (z.B. bei weiteren Löt- oder Entlötvorgängen) wieder abgerufen werden.

Zur Erhöhung des Durchsatzes des Lötofens 10 kann die Lotpastentrocknung vom restlichen Prozeß getrennt werden und z.B. in einem vorgeschalteten Durchlaufofen erfolgen. Zwischen beiden Öfen wird dann eine Ausgleichsschleife eingerichtet. Bei Verwendung von Lotformteilen entfällt die Trocknung, die Höhe der Vorwärmtemperatur bleibt gleich. Die Vorwärmzeit beträgt je nach Art der Leiterplatten 20 bis 40 sec.

Die Regelschaltungen (vorzugsweise mit vorgeschaltetem Mikrorechner) werden über Zeitschaltungen (Relais), oder vorzugsweise über ein Infratrot-Thermometer ("Infrarot-Sensor") 2 (Wellenlänge 5 - 8um oder 8 - 12µm) angesteuert. Der IR-Sensor 2 ist im Ofen 10 angebracht, vgl. Figur 2, und mißt während der gesamten Erwärmungs- und Kühlvorgänge die Temperatur z.B. eines Bauteils oder einer Lötstelle. Über Grenzkontakte schaltet er die einzelnen Betriebsstufen um.

Außerdem werden durch den Infrarot-Sensor 2 die Ventilatoren 8 eingeschaltet und in ihrer Drehzahl geregelt und das Takten des Transportsystems durchgeführt.

Bei vollautomatischem Betrieb, z.B. in einer Fertigungsstraße, können die Leiterplatten-spezifischen Einstelldaten von einem Strichcode, befestigt am Werkstückträger 4 oder einer Leiterplatte 3, automatisch abgelesen und über eine Stellelektronik (z.B. eine speicherprogrammierte Mikrorechnersteuerung und -regelung) eingestellt werden. Auf einem Werkstückträger 4 müssen jedoch immer Leiterplatten 3 vom selben Typ sein. Bei temperaturgesteuertem Betrieb muß zur Ermittlung der Temperatur zusätzlich dafür gesorgt werden, daß jeweils eine der zu bearbeitenden Leiterplatten 3 immer an der Stelle auf dem Werkstückträger 4 angeordnet wird, die von dem IR-Sensor überwacht wird.

Im folgenden wird ein typischer erfindungsgemäßer Verfahrensablauf beim Reflow-Entlöten beschrieben.

Die zu bearbeitenden Leiterplatten 3 mit den zu entlötenden Bauteilen werden entweder durch das Sichtfenster 9 oder über das getaktete Transportsystem an eine bestimmte Stelle im Ofen 10 gebracht. Die übrigen nicht zu entlötenden Bauteile der Leiterplatte 3 werden dabei durch Bleche (vorzugsweise aus unbeschichteten Aluminium) von oben und unten abgedeckt und so vor der IR-Strahlung geschützt.

Vorzugsweise wird bei erst- und/oder einmaligen Reflow-Entlöten an eine Lötstelle des zu entlötenden Bauteils zusätzlich Lötpaste angebracht.

Vergleichbar mit den Vorgängen beim Reflow-Löten wird das zu entlötende Bauteil zunächst bis zu einer bestimmten Lötstellentemperatur (ca. 160°C) vorgewärmt und anschließend bis zur Schmelztemperatur der Lötpaste (ca. 183°C) kurz aufgeheizt. Der Vorgang wird durch das Sichtfenster 9 beobachtet. Schmilzt die Lotpaste, wird das Sichtfenster 9 geöffnet und das zu entlötende Bauteil von Hand z. B. mit einer Pinzette oder einem Greifer von der Leiterplatte 3 abgehoben und entfernt.

Sind auf mehreren gleichartigen Leiterplatten die gleichen Bauteile zu entlöten, wird in einer vorteilhaften Ausführungsform der erfindungsgemäßen Anordnung beim erstmaligen Entlöten der Infrarot-Sensor 2 auf die Schmelztemperatur der zusätzlich aufgebrachten Lötpaste geeicht (z. B. durch manuelles Drücken eines Signalgebers, der mit dem IR-Sensor 2 bzw. dessen Ansteuerung verbunden ist) und die Erzeugung der IR-Strahlung 11 durch die IR-Strahler 1 bei dem nachfolgenden Entlötprozessen ohne zusätzliche Lötpaste direkt durch den IR-Sensor 2 gesteuert.

So ist es z. B. möglich, für den laminar an den Leiterplatten vorbeiströmenden Gasstrom anstelle von Luft ein inertes Schutzgas wie z. B. Stickstoff oder Helium zu verwenden. Von Vorteil kann es auch sein, den Gasstrom in einen geschlossenen Kreislauf mit einer externen Vorrichtung zur Reinigung des Gases zu bewegen, wobei der Ofen Teil dieses geschlossenen Kreislaufs wäre. Weiterhin ist es möglich, die Infrarot-Flächenstrahler während der Abkühlphase (vorzugsweise nach dem Erstarren des Lots) forciert bis auf eine vorgegebene Mindesttemperatur abzukühlen, um reproduzierbare Startbedingungen zu gewährleisten. Ferner kann es von Vorteil sein (insbesondere beim Reflow-Entlöten), die nicht benötigten Infrarot-Flächenstrahler überhaupt nicht einzuschalten. Schließlich ist es möglich, zur forcierten Kühlung der Infrarot-Flächenstrahler den zur Kühlung der Leiterplatten vorgesehenen Gasstrom zu nutzen, indem ein Teil dieses Gasstroms über entsprechende Klappen und Ventile auf die von den Leiterplatten abgewandte Außenseite der Reflektoren der Flächenstrahler geleitet wird.

Die Vorteile der vorliegenden Erfindung sind:
- daß im Ofen nur eine relativ geringe Wärmemenge gespeichert wird, so daß es i. a. beim Abschalten der Anlage in Folge einer Störung im Fertigungsablauf nicht zu einer Zerstörung des Lötguts kommt.
- daß das Lötgut während der kritischen Schmelz- und Erstarrungsphase des Lots im Fertigungsablauf keinen Erschütterungen ausgesetzt ist, die die Festigkeit und das Metallgefüge der Lötstellen negativ beeinflussen würden.
- daß durch die Verwendung paralleler Wärmestrahlen von oben und unten, die senkrecht auf der Ober- bzw. Unterseite der Leiterplatte stehen, zum einen nur die zu entlötenden Bauteile entlötet werden und zum anderen auch keine Abschattungseffekte entstehen, so daß auch Chipcarrier problemlos entlötet werden können.
- daß mit der forcierten Kühlung der IR-Flächenstrahler in der Abkühlphase und dem laminar an den Leiterplatten vorbeigeleiteten Gasstrom zusammen mit dem am Löt- bzw. Entlötort homogen ausgebildete Strahlungsfeld der Flächenstrahler einheitliche und reproduzierbare Löt- bzw. Entlötbedingungen herstellbar sind.

## Patentansprüche

1. Verfahren zum Reflow-Löten oder Reflow-Entlöten von Leiterplatten mittels Infrarotstrahlung aus Strahlergruppen in einem Ofen, bei welchem Verfahren die Leiterplatten in einer ersten Phase in den Ofen eingeführt werden, in einer zweiten Phase gelötet oder entlötet werden und in einer dritten Phase wieder aus dem Ofen herausgeführt werden, wobei die Leiterplatten in einer ersten Zwischenphase zwischen der ersten und der zweiten Phase in dem Ofen vorgewärmt werden, dadurch gekennzeichnet,
- daß die Leiterplatten (3) in einer zweiten Zwischenphase zwischen der zweiten und dritten Phase in dem Ofen (10) abgekühlt werden;
- daß ein getaktetes Transportsystem zur Anwendung kommt, das während der Vorwärm-, Abkühl- und Löt/Entlötphasen stillsteht, sodaß die Leiterplatten (3) in der Vorwärm- und Abkühl-Zwischenphase und der Löt- oder Entlötphase in dem Ofen (10) nicht bewegt werden;
- daß die Infrarotstrahlung (11) im wesentlichen nur während der Vorwärm-Zwischenphase und der Löt- oder Entlötphase erzeugt wird;
- daß die Strahlergruppen (1) während der Vorwärm-Zwischenphase für eine erste vorgegebene Zeit mit reduziertem Betriebsstrom und während der Löt- oder Entlötphase für eine zweite vorgegebene Zeit auf einem höchsten vorgegebenen Betriebsstrom betrieben werden.

2. Verfahren nach Anspruch 1, dadurch gekennzeichnet, daß die Infrarotstrahlung (11) am Löt- oder Entlötort im Ofen (10) nahezu homogen ist und aus einer Vielzahl von nahezu parallelen Wärmestrahlen gebildet wird, die von den Strahlergruppen (1) erzeugt werden und nahezu senkrecht auf der Ober- bzw. Unterseite der Leiterplatten (3) stehen.

3. Verfahren nach einem der Ansprüche 1 bis 2, dadurch gekennzeichnet, daß die Dauer der Vorwärm- und Abkühl-Zwischenphase und der Löt- oder Entlötphase durch vorgegebene Werte der Lötstellentemperatur auf den Leiterplatten (3) bestimmt wird, derart, daß bei Erreichen eines dieser Werte die jeweils zugeordnete Phase oder Zwischenphase beendet und die nachfolgende Zwischenphase oder Phase begonnen wird.

4. Verfahren nach Anspruch 3, dadurch gekennzeichnet, daß die Lötstellentemperatur auf den Leiterplatten (3) mittels mindestens eines Infrarotsensors (2) ermittelt wird.

5. Verfahren nach einem der Ansprüche 1 bis 4, dadurch gekennzeichnet, daß zum Absaugen der beim Löten oder Entlöten entstehenden Lötdämpfe und/oder zum Abkühlen der gelöteten oder entlöteten Leiterplatten (3) ein Gasstrom mittels mindestens eines Ventilators (8) in dem Ofen (10) an den Leiterplatten (3) vorbeigeführt wird.

6. Verfahren nach Anspruch 5, dadurch gekennzeichnet, daß mindestens während der Vorwärm-Zwischenphase und der Löt- oder Entlötphase sowie während der Abkühl-Zwischenphase bis zum Erstarren des Lots auf den Leiterplatten (3) der Gasstrom laminar an den Leiterplatten (3) vorbeigeführt wird.

7. Verfahren nach einem der Ansprüche 5 bis 6, dadurch gekennzeichnet, daß die Strömungsgeschwindigkeit des Gasstroms mittels mindestens eines die Drehzahl des mindestens einen Ventilators (8) regelnden Strömungssensors (6) geregelt wird und daß sie mindestens während der Vorwärm-Zwischenphase und der Löt- oder Entlötphase sowie während der Abkühl-Zwischenphase bis zum Erstarren des Lots auf den Leiterplatten (3) durch die Regelung auf einem konstanten Wert gehalten wird, der kleiner oder gleich ist einem vorgegebenen Wert.

8. Verfahren nach Anspruch 7, dadurch gekennzeichnet, daß die Strömungsgeschwindigkeit des Gasstroms während der Abkühl-Zwischenphase nach dem Erstarren des Lots auf den Leiterplatten (3) auf einen Wert erhöht wird, der zwischen dem vorgegebenen Wert und dem Maximalwert liegt oder gleich dem Maximalwert ist.

9. Verfahren nach einem der Ansprüche 5 bis 8, dadurch gekennzeichnet, daß die Strahlergruppen (1) während der Abkühl-Zwischenphase bis auf eine vorgegebene Mindesttemperatur forciert abgekühlt werden.

10. Verfahren nach einem der Ansprüche 1 bis 9, dadurch gekennzeichnet,
- daß die Leiterplatten (3) auf einem getakteten und während der Vorwärm- und Abkühl-Zwischenphase und der Löt- oder Entlötphase stillstehenden Band oder Werkstückträger (4) in den Ofen (10) gefahren werden;
- daß der mindestens eine Ventilator (8) während der Vorwärm-Zwischenphase und der Löt- oder Entlötphase und während der Abkühl-Zwischenphase bis zum Erstarren des Lots auf den Leiterplatten (3) mit reduzierter Drehzahl und während der Abkühlphase nach dem Erstarren des Lots mit voller Drehzahl betrieben wird;
- daß nach Beendigung der Abkühl-Zwischenphase die gelöteten oder entlöteten Leiterplatten (3) auf dem getakteten Band oder Werkstückträger (4) aus dem Ofen (10) herausgefahren werden.

11. Verfahren nach einem der Ansprüche 1 bis 10 mit Verwendung von Lotpasten, dadurch gekennzeichnet, daß beim Reflow-Löten zur Lotpastentrocknung die Leiterplatten (3) durch einen vorgeschalteten Durchlaufofen geführt werden.

12. Verfahren nach einem der Ansprüche 1 bis 10, dadurch gekennzeichnet, daß beim Reflow-Entlöten von einzelnen Bauteilen auf den Leiterplatten (3) die übrigen nicht zu erwärmenden Bauteile auf den Leiterplatten (3) durch je ein Blech von oben und von unten abgedeckt werden und daß das zu entlötende Bauteil nach dem Schmelzen des Lots durch ein aufklappbares Sichtfenster (9) von Hand mittels einer Pinzette oder eines Greifers abgehoben und entfernt wird.

13. Verfahren nach Anspruch 12, dadurch gekennzeichnet, daß an einer Lötstelle des zu entlötenden Bauteils auf der Leiterplatte (3) zusätzlich Lotpaste aufgebracht wird und das Bauteil erst nach Schmelzen dieser Lotpaste abgehoben und entfernt wird.

14. Anordnung zur Durchführung des Verfahrens nach Anspruch 1, bei welcher
- durch einen Ofen (10) ein Leiterplatten (3) transportierendes, während der Vorwärm-, Abkuhl- und Löt/Entlötphasen stillstehendes Transportsystem mit einem getakteten Antriebssystem geführt ist;
- im Ofen (10) über und/oder unter dem Transportsystem im gleichen Abstand zu den transportierten Leiterplatten (3) jeweils mehrere Infrarot-Flächenstrahler (1) nebeneinander und/oder hintereinander angeordnet sind;
- die Infrarot-Flächenstrahler (1) jeweils Regelschaltungen für den Betriebsstrom aufweisen;
- zur Erzeugung eines Gasstroms mit einer horizontalen Strömungsrichtung quer zur Transportrichtung der Leiterplatten (3) im Ofen (10) auf der einen Seite des Transportsystems ein erster Schacht (5) mit einem ersten Ventilator (8) zum Ansaugen des Gases und auf der anderen Seite des Transportsystems ein zweiter Schacht (5) mit einem zweiten Ventilator (8) zum Absaugen des Gases und der Lötdämpfe vorgesehen ist;
- die Ventilatoren (8) jeweils Regelschaltungen für ihre Antriebsmotoren (M) aufweisen.

15. Anordnung nach Anspruch 14, dadurch gekennzeichnet, daß die Regelschaltungen für die Antriebsmotoren (M) der Ventilatoren (8) jeweils einen in dem zugehörigen Schacht (5) befindlichen Strömungssensor (6) enthalten.

16. Anordnung nach einem der Ansprüche 14 bis 15, dadurch gekennzeichnet, daß das Gas von außen angesaugte bzw. nach außen abgegebene Luft ist.

17. Anordnung nach einem der Ansprüche 14 bis 15, dadurch gekennzeichnet, daß sich am Ausgang des Schachtes (5) zum Absaugen des Gases und der Lötdämpfe zusätzlich noch ein ungeregelter Ventilator (7) befindet und daß der Kanal (5) an dieser Stelle zusätzliche Ansaugöffnungen für die Außenluft aufweist.

18. Anordnung nach einem der Ansprüche 14 bis 15, dadurch gekennzeichnet, daß das Gas ein inertes Gas, insbesondere Stickstoff, ist.

19. Anordnung nach Anspruch 18, dadurch gekennzeichnet, daß das Gas in einen geschlossenen Kreislauf durch den Ofen (10) geführt ist und daß dieser Kreislauf eine externe Vorrichtung zur Reinigung des Gases aufweist.

20. Anordnung nach einem der Ansprüche 14 bis 19, dadurch gekennzeichnet, daß die Regelschaltungen über einstellbare Zeitschaltungen ansteuerbar sind.

21. Anordnung nach einem der Ansprüche 14 bis 19, dadurch gekennzeichnet, daß im Ofen ein Infrarot-Thermometer (2) angebracht ist, welches über Grenzkontakte die Regelschaltungen ansteuert.

22. Anordnung nach einem der Ansprüche 20 bis 21, dadurch gekennzeichnet, daß die Zeitschaltungen und die Höhen der Betriebsströme durch am Transportsystem oder an den Leiterplatten angebrachte Strichcodes einstellbar sind.

23. Anordnung nach einem der Ansprüche 14 bis 22, dadurch gekennzeichnet, daß an der dem Absaugschacht (5) gegenüberliegenden Seitenwand des Ofens (10) in der Mitte, etwa in der Höhe des Transportsystems, ein aufklappbares Sichtfenster (9) angebracht ist.

24. Anordnung nach Anspruch 23, dadurch gekennzeichnet, daß das Sichtfenster aus durchsichtigem Material besteht.

25. Anordnung nach einem der Ansprüche 14 bis 23, dadurch gekennzeichnet, daß die Bleche zum Abdecken der Leiterplatten (3) beim Reflow-Entlöten aus unbeschichtetem Aluminiumblech bestehen.

26. Anordnung nach einem der Ansprüche 14 bis 25, dadurch gekennzeichnet, daß zur Steuerung und Regelung der Vorgänge eine speicherprogrammierbare Mikrorechnersteuerung und -regelung vorgesehen ist.

27. Anordnung nach Anspruch 26, dadurch gekennzeichnet, daß die Einstellparameter in der Mikrorechnersteuerung und -regelung abgespeichert sind und zum Löten- oder Entlöten gleichartiger Leiterplatten (3) bzw. gleichartiger Bauteile auf gleichartigen Leiterplatten (3) ohne Korrektur verwendbar sind.

## Claims

1. Method for the reflow-soldering or reflow-unsoldering of printed circuit boards by means of infra-red radiation from radiator groups in a furnace, in which method the printed circuit boards are introduced into the furnace in a first phase, are soldered or unsoldered in a second phase and again led out of the furnace in a third phase, wherein the printed circuit boards are preheated in the furnace in a first intermediate phase between the first and the second phase, characterised thereby,
- that the printed circuit boards (3) are cooled down in the furnace (10) in a second intermediate phase between the second and the third phase,
- that a keyed transport system comes into use, which stands still during the phases of preheating, cooling and soldering or unsoldering so that the printed circuit boards (3) are not moved in the furnace (10) during the intermediate phases of preheating and cooling-down or the phase of soldering or unsoldering,
- that the infra-red radiation (11) is produced substantially only during the intermediate preheating phase and the phase of soldering or unsoldering and
- that the radiator groups (1) are operated at reduced operating current for a first preset time during the intermediate preheating phase and at a highest preset operating current for a second preset time during the phase of soldering or unsoldering.

2. Method according to claim 1, characterised thereby, that the infra-red radiation (11) is almost homogeneous at the place of soldering or unsoldering in the furnace (10) and is formed of a plurality of almost parallel heat rays which are produced by the radiator groups (1) and stand almost perpendicularly on the upper side or the underside of the printed circuit boards (3).

3. Method according to one of the claims 1 and 2, characterised thereby, that the duration of the intermediate phases of preheating and cooling-down and the phase of soldering or unsoldering is determined by preset values of the soldering place temperature on the printed circuit boards (3) in such a manner that the respectively associated phase or intermediate phase is terminated and the following intermediate phase or phase is commenced on reaching one of these values.

4. Method according to claim 3, characterised thereby, that the soldering place temperature on the printed circuit boards (3) is ascertained by means of at least one infra-red sensor (2).

5. Method according to one of the claims 1 to 4, characterised thereby, that a gas flow is guided past the printed circuit boards (3) by means of at least one fan (8) in the furnace (10) for the extraction of the solder vapours arising during the soldering or unsoldering and/or for the cooling of the soldered or unsoldered printed circuit boards (3).

6. Method according to claim 5, characterised thereby, that the gas flow is guided laminarly past the printed circuit boards (3) at least during the intermediate preheating phase and the phase of soldering or unsoldering as well as during the intermediate cooling-down phase up to the solidification of the solder on the printed circuit boards (3).

7. Method according to one of the claims 5 and 6, characterised thereby, that the speed of the gas flow is regulated by means of at least one flow sensor (6) regulating the rotational speed of the at least one fan (8) and that it is kept at a constant value, which is smaller than or equal to a preset value, by the regulation at least during the intermediate preheating phase and the phase of soldering or unsoldering as well as during the intermediate cooling-down phase up to the solidification of the solder on the printed circuit boards (3).

8. Method according to claim 7, characterised thereby, that the speed of the gas flow is increased to a value, which lies between the preset value and the maximum value or is equal to the maximum value, during the intermediate cooling-down phase after the solidification of the solder on the printed circuit boards (3).

9. Method according to one of the claims 5 to 8, characterised thereby, that the radiator groups (1) are force-cooled to a preset minimum temperature during the intermediate cooling-down phase.

10. Method according to one of the claims 1 to 9, characterised thereby,
- that the printed circuit boards (3) are moved into the furnace (10) on a keyed belt or workpiece carrier (4), which stands still during the intermediate phases of preheating and cooling-down and the phase of soldering or unsoldering,
- that the at least one fan (8) is operated at reduced rotational speed during the intermediate preheating phase and the phase of soldering or unsoldering and during the intermediate cooling-down phase up to the solidification of the solder on the printed circuit boards (3) and at full rotational speed after the solidification of the solder during the cooling phase and
- that the soldered or unsoldered printed circuit boards (3) are moved out of the furnace (10) on the keyed belt or workpiece carrier (4) after termination of the intermediate cooling-down phase.

11. Method according to one of the claims 1 to 10 with the use of soldering pastes, characterised thereby, that during reflow-soldering, the printed circuit boards (3) are guided through an upstream tunnel furnace for the drying of the soldering paste.

12. Method according to one of the claims 1 to 10, characterised thereby, that during the reflow-unsoldering of individual components on the printed circuit boards (3), the remaining and not to be heated components on the printed circuit boards (3) are each covered from above and below by a respective metal plate and that the component to be unsoldered is lifted off and removed manually by means of a tweezers or a gripper through a viewing window (9), which is tiltable open, after the melting of the solder.

13. Method according to claim 12, characterised thereby, that additional soldering paste is applied at a soldering place of the component to be unsoldered on the printed circuit board (3) and the component is lifted off and removed only after the melting of this soldering paste.

14. Arrangement for the performance of the method according to claim 1, in which arrangement
- a transport system, which transports printed circuit boards (3) and which stands still during the phases of preheating, cooling and soldering or unsoldering, with a keyed drive system is led through a furnace,
- several areal infra-red radiators (1) are arranged, one beside the other and/or one behind the other each time at the same spacing from the transported printed circuit boards (3), in the furnace (10) and above and/or below the transport system,
- the areal infra-red radiators (1) each display respective regulating circuits for the operating current,
- a first shaft (5) with a first fan (8) for the induction of a gas is provided on the one side of the transport system and a second shaft (5) with a second fan (8) for the extraction of the gas and the solder vapours is provided on the other side of the transport system for the production of a gas flow with an horizontal direction of flow transversely to the direction of transport of the printed circuit boards (3) through the furnace (10) and
- the fans (8) each display respective regulating circuits for their drive motors (M).

15. Arrangement according to claim 14, characterised thereby, that the regulating circuits for the drive motors (M) of the fans (8) each contain a respective flow sensor (6) disposed in the associated shaft (5).

16. Arrangement according to one of the claims 14 and 15, characterised thereby, that the gas is air inducted from or exhausted to the outside.

17. Arrangement according to one of the claims 14 and 15, characterised thereby, that an unregulated fan (7) is additionally still disposed at the exit of the shaft (5) for the extraction of the gas and the solder vapours and that the channel (5) at this place displays additional induction openings for the external air.

18. Arrangement according to one of the claims 14 and 15, characterised thereby, that the gas is an inert gas, in particular nitrogen.

19. Arrangement according to claim 18, characterised thereby, that the gas is conducted through the furnace (10) in a closed circuit and that this circuit displays an external device for the purification of the gas.

20. Arrangement according to one of the claims 14 to 19, characterised thereby, that the regulating circuits are selectively drivable by way of settable timing circuits.

21. Arrangement according to one of the claims 14 to 19, characterised thereby, that an infra-red thermometer (2), which selectively drives the regulating circuits by way of limit contacts, is mounted in the furnace (10).

22. Arrangement according to one of the claims 20 and 21, characterised thereby, that the timing circuits and the values of the operating currents are settable by bar codes arranged at the transport system or at the printed circuit boards (3).

23. Arrangement according to one of the claims 14 to 22, characterised thereby, that a viewing window (9), which is tiltable open, is mounted at that side wall of the furnace (10), which lies opposite the extraction shaft (5), in the middle and at about the height of the transport system.

24. Arrangement according to claim 23, characterised thereby, that the viewing window consists of transparent material.

25. Arrangement according to one of the claims 14 to 23, characterised thereby, that the metal plates for the covering of the printed circuit boards (3) during the reflow-unsoldering consist of uncoated aluminium plates.

26. Arrangement according to one of the claims 14 to 25, characterised thereby, that a stored program microcomputer control and regulation is provided for the control and regulation of the operations.

27. Arrangement according to claim 26, characterised thereby, that the setting parameters are stored in the microcomputer control and regulation and usable without correction for the soldering or unsoldering of similar printed circuit boards (3) or similar components on similar printed circuit boards (3).

## Revendications

1. Procédé de brasage par refusion ou de débrasage par refusion de circuits imprimés au moyen d'un rayonnement infrarouge provenant de groupes de radiateurs dans un four, selon lequel les circuits imprimés sont introduits dans le four dans un première phase, brasés ou débrasés dans une deuxième phase et évacués de nouveau hors du four dans une troisième phase, avec préchauffage des circuits imprimés à l'intérieur du four dans une première phase intermédiaire entre les première et deuxième phases, caractérisé en ce
- que les circuits imprimés (3) sont refroidis à l'intérieur du four (10) dans une deuxième phase intermédiaire entre les deuxième et troisième phases;
- qu'un système de transport avancé périodiquement est utilisé, système qui est arrêté pendant les phases de préchauffage, de refroidissement et de brasage/ débrasage, de sorte que les circuits imprimés (3) ne sont pas déplacés à l'intérieur du four (10) dans les phases intermédiaires de préchauffage et de refroidissement, ni dans les phases de brasage ou de débrasage;
- que le rayonnement infrarouge (11) est produit seulement, pour l'essentiel, pendant la phase intermédiaire de préchauffage et la phase de brasage ou de débrasage; et
- que les groupes de radiateurs (1) sont alimentés avec un courant de service réduit durant un premier temps préfixé pendant la phase intermédiaire de préchauffage et avec un courant de service maximal préfixé durant un deuxième temps préfixé pendant la phase de brasage ou de débrasage.

2. Procédé selon la revendication 1, caractérisé en ce que le rayonnement infrarouge (11) à l'endroit de brasage ou de débrasage à l'intérieur du four (10) est presque homogène et formé d'un grand nombre de rayons de chaleur presque parallèles, qui sont produits par les groupes de radiateurs (1) et sont presque perpendiculaires au côté supérieur ou au côté inférieur des circuits imprimés (3).

3. Procédé selon la revendication 1 ou 2, caractérisé en ce que la durée des phases intermédiaires de préchauffage et de refroidissement et de la phase de brasage ou de débrasage est déterminée par des valeurs préfixées de la température des points de brasage sur les circuits imprimés (3), de telle sorte que lorsque l'une des ces valeurs est atteinte, la phase ou la phase intermédiaire coordonnée est arrêtée et la phase intermédiaire ou la phase suivante est commencée.

4. Procédé selon la revendication 3, caractérisé en ce que la température des points de brasage sur les circuits imprimés (3) est déterminée au moyen d'au moins un capteur à infrarouge (2).

5. Procédé selon une des revendications 1 à 4, caractérisé en ce que, pour l'évacuation par aspiration des vapeurs de brasage produites lors du brasage ou du débrasage et/ou le refroidissement des circuits imprimés (3) brasés ou débrasés, un courant gazeux est amené à passer devant les circuits imprimés (3) à l'intérieur du four (10) par au moins un ventilateur (8).

6. Procédé selon la revendication 5, caractérisé en ce que le courant gazeux est amené à passer par un écoulement laminaire devant les circuits imprimés (3) pendant au moins la phase intermédiaire de préchauffage et la phase de brasage ou de débrasage, ainsi que pendant la phase intermédiaire de refroidissement jusqu'à la solidification de la brasure sur les circuits imprimés (3).

7. Procédé selon la revendication 5 ou 6, caractérisé en ce que la vitesse d'écoulement du courant gazeux est régulée au moyen d'au moins un capteur d'écoulement (6) qui règle la vitesse de rotation du ou des ventilateurs (8), et que cette vitesse est maintenue par la régulation à une valeur constante inférieure ou égale à une valeur préfixée pendant au moins la phase intermédiaire de préchauffage et la phase de brasage ou de débrasage, ainsi que pendant la phase intermédiaire de refroidissement jusqu'à la solidification de la brasure sur les circuits imprimés (3).

8. Procédé selon la revendication 7, caractérisé en ce que, pendant la phase intermédiaire de refroidissement, à la suite de la solidification de la brasure sur les circuits imprimés (3), la vitesse d'écoulement du courant gazeux est augmentée à une valeur comprise entre la valeur préfixée et la valeur maximale ou égale à la valeur maximale.

9. Procédé selon une des revendications 5 à 8, caractérisé en ce que les groupes de radiateurs (1) sont refroidis de façon forcée, pendant la phase intermédiaire de refroidissement, jusqu'à une température minimale préfixée.

10. Procédé selon une des revendications 1 à 9, caractérisé en ce
- que les circuits imprimés (3) sont introduits dans le four (10) sur une bande ou une porte-pièce (4) qui est immobilisée pendant les phases intermédiaires de préchauffage et de refroidissement et la phase de brasage ou de débrasage;
- que le ventilateur (8), ou chacun de plusieurs ventilateurs (8), est utilisé à vitesse de rotation réduite pendant la phase intermédiaire de préchauffage et la phase de brasage ou de débrasage, ainsi que pendant la phase intermédiaire de refroidissement jusqu'à la solidification de la brasure sur les circuits imprimés (3), et est utilisé à pleine vitesse de rotation pendant la phase de refroidissement à la suite de la solidification de la soudure;
et
- que, après la fin de la phase intermédiaire de refroidissement, les circuits imprimés (3) brasés ou débrasés, sont sortis du four (10) sur la bande ou la porte-pièce (4), avancée de façon périodique.

11. Procédé selon une des revendications 1 à 10, avec utilisation de pâtes à braser, caractérisé en ce que, pour le séchage de la pâte à braser dans le brasage par refusion, les circuits imprimés (3) sont amenés à passer à travers un four continu prévu en amont.

12. Procédé selon une des revendications 1 à 10, caractérisé en ce que, lors du débrasage par refusion de composants individuels sur les circuits imprimés (3), les autres composants se trouvant sur les circuits imprimés (3) et ne devant pas être échauffés, sont recouverts en haut et en bas, chaque fois par un écran en tôle, et que le composant à débraser, après la fusion de la brasure, est détaché et retiré manuellement, au moyen d'une pincette ou d'un préhenseur, à travers une fenêtre d'observation (9) relevable.

13. Procédé selon la revendication 12, caractérisé en ce que de la pâte à souder supplémentaire est appliquée sur un joint brasé du composant à débraser se trouvant sur un circuit imprimé (3) et le composant est seulement détaché et retiré après la fusion de cette pâte.

14. Dispositif pour la mise en oeuvre du procédé selon la revendication 1, dans lequel
- un four (10) est traversé d'un système de transport muni d'un entraînement commandé périodiquement, qui transporte des circuits imprimés (3) et est arrêté pendant les phases de préchauffage, de refroidissement et de brasage/débrasage; - plusieurs radiateurs à infrarouge de surface (1) sont juxtaposés et/ou placés les uns derrière les autres au-dessus et/ou au-dessous du système de transport, à égale distance des circuits imprimés (3) transportés;
- les radiateurs à infrarouge de surface (1) présentent chacun des dispositifs de réglage pour le courant de service;
- un premier conduit (5) avec un premier ventilateur (8) pour aspirer le gaz à l'intérieur sont prévus d'un côté du système de transport et un second conduit (5) avec un second ventilateur (8) pour l'évacuation du gaz et des vapeurs de brasage sont prévus de l'autre côté du système de transport, en vue de la création d'un courant gazeux ayant une direction d'écoulement horizontale transversalement à la direction de transport des circuits imprimés (3) à l'intérieur du four (10); et
- les ventilateurs (8) sont pourvus chacun de circuits de réglage pour leurs moteurs d'entraînement (M).

15. Dispositif selon la revendication 14, caractérisé en ce que les circuits de réglage pour les moteurs d'entraînement (M) des ventilateurs (8) contiennent chacun un capteur d'écoulement (6) se trouvant dans le conduit (5) coordonné.

16. Dispositif selon la revendication 14 ou 15, caractérisé en ce que le gaz, aspiré de l'extérieur et évacué à l'extérieur, est de l'air.

17. Dispositif selon la revendication 14 ou 15, caractérisé en ce qu'un ventilateur (7) non réglé se trouve en plus à la sortie du conduit (5) pour l'évacuation du gaz et des vapeurs de brasage et que le conduit (5) présente à cet endroit des orifices supplémentaires d'aspiration d'air extérieur.

18. Dispositif selon la revendication 14 ou 15, caractérisé en ce que le gaz est un gaz inerte, en particulier de l'azote.

19. Dispositif selon la revendication 18, caractérisé en ce que le gaz est amené à circuler dans un circuit fermé passant par le four (10) et que ce circuit comporte un dispositif externe pour l'épuration du gaz.

20. Dispositif selon une des revendications 14 à 19, caractérisé en ce que les circuits de réglage sont pilotables par des circuits temporisés ajustables.

21. Dispositif selon une des revendications 14 à 19, caractérisé en ce qu'un thermomètre à infrarouge (2) est disposé à l'intérieur du four pour piloter les circuits de réglage par des contacts actionnés à certaines limites.

22. Dispositif selon la revendication 20 ou 21, caractérisé en ce que les circuits temporisés et les intensités des courants de service sont ajustables par des codes à barres disposés sur le système de transport ou sur les circuits imprimés.

23. Dispositif selon une des revendications 14 à 22, caractérisé en ce qu'une fenêtre d'observation (9) relevable est incorporée dans la paroi latérale du four (10) située à l'opposé du conduit d'évacuation (5), au milieu, à peu près à la hauteur du système de transport.

24. Dispositif selon la revendication 23, caractérisé en ce que la fenêtre d'observation est en matériau transparent.

25. Dispositif selon une des revendications 14 à 23, caractérisé en ce que les écrans pour recouvrir les circuits imprimés (3) lors du débrasage par refusion sont en tôle d'aluminium non revêtu.

26. Dispositif selon une des revendications 14 à 25, caractérisé en ce qu'un système de commande et de régulation à microcalculateur programmable par mémoire est prévu pour commander et réguler les processus.

27. Dispositif selon la revendication 26, caractérisé en ce que les paramètres dé réglage sont mémorisés dans le système de commande et de régulation à microcalculateur et utilisables sans correction pour le brasage de circuits imprimés (3) de même type ou pour le débrasage de composants de même type sur des circuits imprimés (3) de même type.
